# EUROPEAN PATENT APPLICATION

(11) **EP 1 981 091 A1**
(43) Date of publication of application: **15.10.2008**
(21) Application number: 07707715.4
(22) Date of filing: 30.01.2007
(51) Int. Cl.: H01L 31/042, H01L 31/04, C23C 2/14, C22C 28/00, B23K 35/26, G02F 1/1345

(54) **IN SOLDER COVERED COPPER FOIL RIBBON CONDUCTOR WIRE AND ITS CONNECTION METHOD**

(30) Priority: 31.01.2006 JP 2006022703
(71) Applicant: Showa Shell Sekiyu Kabushiki Kaisha, Minato-ku Tokyo 135-8074 (JP)
(72) Inventor: TAZAWA, Kenichi, Minato-ku Tokyo 135-8074 (JP)
(74) Representative: HOFFMANN EITLE
(86) International application number: PCT/JP2007/051497
(87) International publication number: WO 2007/088851

(57) **Abstract**

A method for tenaciously connecting a conductor electrode on a glass substrate to a ribbon conductor with certainty at low cost without causing damage. An indium-solder-coated copper foil ribbon conductor 1 obtained by depositing an indium solder 3 (100-90% indium and 10-0% silver) in a thickness of 100 µm or smaller on one side of a copper foil or tin-coated copper foil 2 having a thickness of 300 µm or smaller and optionally further depositing the solder thinly on the other surfaces of the foil is placed on an exposed part of a molybdenum-based metallic back electrode layer 4B on a glass substrate 4A. An ultrasonic soldering iron 5 is then placed against the upper side of the copper foil ribbon conductor 1 to melt the indium solder 3 and connect the copper foil ribbon conductor 1 to the electrode layer 4B.

Another method includes soldering an indium solder 3 (having the same composition as shown above) to the electrode layer 4B beforehand, subsequently placing a ribbon-form copper foil or tin-plated copper foil 2 thereon, and connecting the copper foil 2 to the electrode layer 4B with an ultrasonic soldering iron 5.

## Description

### TECHNICAL FIELD

The present invention relates to an indium-solder-coated copper foil ribbon conductor for use in conductor-to-conductor connection in an electronic apparatus mounted on a glass substrate. The invention further relates to a method of the connection.

### BACKGROUND ART

In the case where an electronic device such as, e.g., a semiconductor part is mounted on a printed wiring board or a substrate made of a material other than glass, such as a plastic resin, use of a lead-containing solder is avoided in, e.g., connecting an electrode of the electronic device to a circuit wiring on the substrate or connecting the circuit wiring to an external electrode, from the standpoints of environmental issues, substrate materials, the materials and properties of electrodes, circuit wirings, and the like, productivity, etc. Special solder materials and soldering methods are being developed for such applications.
Methods for connecting an electrode of a semiconductor device in the electronic device such as a semiconductor part to a circuit wiring on the substrate or for connecting the circuit wiring to an external electrode include: a method in which a solder containing indium is used to bond and connect the conductors by the ultrasonic compression bonding method (see, for example, patent document 1); a method in which a conductive resin containing indium is used to connect the conductors while applying ultrasonic with an ultrasonic tool to the connection part (see, for example, patent document 2); and a method in which a conductive adhesive containing indium is used to connect the conductors while applying ultrasonic vibration to the connection part (see, for example, patent document 3).
Furthermore, for the same application, i.e., for connecting an electrode of a semiconductor device in the electronic device such as a semiconductor part to a circuit wiring on the substrate or for connecting the circuit wiring to an external electrode, there also is: a solder obtained by depositing indium on the surface of a solder base containing tin or a method of connecting conductors with this solder; or a method in which the surface of the electrode, circuit wiring, or external electrode or the like is coated with indium and is solder compression-bonded and fixed without using a solder (see, for example, patent document 4). The document discloses that this method attains a high strength of bonding between the indium and the copper which is the material of the circuit wiring or the like and that the indium, which is soft, has the effect of mitigating the strain caused by a difference in the coefficient of thermal expansion between the materials connected.

Patent Document 1: JP-A-10-84055
Patent Document 2: JP-A-2000-332373
Patent Document 3: JP-A-2002-76587
Patent Document 4: Domestic Re-publication of PCT Patent Application WO 97/00753

The electronic apparatus to which the invention is intended to be applied are, for example, thin-film solar cells and the like. These electronic apparatus are formed on a glass substrate. The materials of the electrode films (or layers) or conductive films (or layers) in these apparatus are a metal other than copper, such as, e.g., molybdenum, or ITO (transparent conductive film), and these films (or layers) have an exceedingly small thickness and low mechanical strength and are apt to be damaged. Because of this, when such a metallic back electrode layer is to be connected to a ribbon-form tin-plated copper foil (ribbon conductor), it has been difficult for a connecting method employing any of the conventional solders to bond the metallic back electrode layer to the ribbon conductor with certainty without damaging the metallic back electrode layer.
The electronic devices including semiconductors described in patent documents 1 to 4 are intended to be mounted on printed wiring boards or substrates made of a material other than glass, such as, e.g., a plastic resin. These electronic devices differ considerably in the material of the electrode film (or layer) or conductive film (or layer) and in the thickness and mechanical strength of the film (or layer). It is therefore difficult to directly divert the method of conductor connection in such electronic devices including semiconductors mounted on those substrates other than glass substrates to a method of connecting a conductor of an electronic apparatus mounted on a glass substrate, as in the invention.

### DISCLOSURE OF THE INVENTION

### PROBLEM THAT THE INVENTION IS TO SOLVE

The invention eliminates the problem described above. An object of the invention is to provide: an indium-solder-coated copper foil ribbon conductor which is effective in reducing the amount of an indium solder to be used, which is expensive, to thereby reduce production cost and which enables conductors to be tenaciously connected with ease; and a process for producing the ribbon conductor. Another object of the invention is to provide a method of connecting a copper foil or tin-plated copper foil ribbon conductor in which the indium-solder-coated copper foil ribbon conductor or an indium solder is used to tenaciously bond the ribbon conductor to an electrode film or conductive film with certainty through a small number of simple steps without damaging the electrode film or conductor film and which, due to the soft indium, is effective in mitigating the strain caused by a difference in the coefficient of thermal expansion between the materials connected.

### MEANS FOR SOLVING THE PROBLEM

(1) The invention, which is for eliminating the problem, provides an indium-solder-coated copper foil ribbon conductor which comprises a long ribbon-form copper foil or tin-plated copper foil which has been coated with an indium solder on one side only or coated with an indium solder thickly on one side and thinly in the other parts.

(2) The invention provides the indium-solder-coated copper foil ribbon conductor as described under (1) above, wherein the long ribbon-form copper foil or tin-plated copper foil has a thickness of 300 µm or smaller, the indium solder has a composition comprising 100-90% by weight of indium and 10-0% by weight of silver, and the indium solder deposited on the one side has a thickness of 100 µm or smaller.

(3) The invention provides the indium-solder-coated copper foil ribbon conductor as described under (1) or (2) above, which is for use in connecting a CIS based thin-film solar cell circuit (submodule) to another CIS based thin-film solar cell circuit or to another electrical element, the CIS based thin-film solar cell circuit comprising a glass substrate and CIS based thin-film solar cell device parts disposed thereon which each comprise a metallic back electrode layer comprising molybdenum, an alkali barrier layer, a light absorption layer, a buffer layer, and a window layer (transparent electrode layer) in this order and which have been electrically connected to each other with a conductive pattern.

(4) The invention provides the indium-solder-coated copper foil ribbon conductor as described under (1) or (2) above, which is for use in an electronic apparatus comprising a glass substrate and, disposed thereon, a metallic electrode and an electronic device, the ribbon conductor being used for electrically connecting the metallic electrode to the electronic device or for electrically connecting the metallic electrode to an external electrode.

(5) The invention provides a process for producing an indium-solder-coated copper foil ribbon conductor, which comprises immersing a long ribbon-form copper foil or tin-plated copper foil, gradually from an end thereof, in a molten indium solder, subsequently drawing the foil out of the molten indium solder, and removing (wiping off) the molten indium solder adherent to the lower side of the copper foil with a solder remover, e.g., a metallic spatula, to coat either of the upper and lower sides of the copper foil or tin-plated copper foil with the indium solder.

(6) The invention provides a process for producing an indium-solder-coated copper foil ribbon conductor, which comprises immersing a long ribbon-form copper foil or tin-plated copper foil, gradually from an end thereof, in a molten indium solder to coat the whole periphery of the ribbon-form copper foil or tin-plated copper foil with the indium solder, subsequently drawing the coated foil out of the molten indium solder, and removing (wiping off) the molten indium solder adherent to the lower side of the copper foil with a solder remover, e.g., a metallic spatula, to regulate the indium solder deposited on the upper side so as to have a larger thickness than the indium solder deposited on the lower side.

(7) The invention provides the process for producing an indium-solder-coated copper foil ribbon conductor as described under (5) or (6) above, wherein the long ribbon-form copper foil or tin-plated copper foil has a thickness of 300 µm or smaller, the indium solder has a composition comprising 100-90% by weight of indium and 10-0% by weight of silver, and the indium solder deposited on the one side has a thickness of 100 µm or smaller.

(8) The invention provides a method of connecting a copper foil ribbon conductor for CIS based thin-film solar cell module production, which is for connecting a CIS based thin-film solar cell circuit (submodule) to another CIS based thin-film solar cell circuit or to another electrical element, the CIS based thin-film solar cell circuit comprising a glass substrate and CIS based thin-film solar cell device parts disposed thereon which each comprise a metallic back electrode layer comprising molybdenum, an alkali barrier layer, a light absorption layer, a buffer layer, and a window layer (transparent electrode layer) in this order and which have been electrically connected to each other with a conductive pattern,
wherein the method comprises: coating a long ribbon-form copper foil or tin-plated copper foil with an indium solder on one side only or with an indium solder thickly on one side and thinly in the other parts; placing the resultant indium-solder-coated copper foil ribbon conductor on an exposed part of the metallic back electrode layer so that the one side thickly coated with the indium solder is in contact with the metallic back electrode layer; and pushing an ultrasonic soldering iron against the upper side of the indium-solder-coated copper foil ribbon conductor to melt the indium solder and connect the indium-solder-coated copper foil ribbon conductor to the metallic back electrode layer.

(9) The invention provides a method of connecting a copper foil ribbon conductor in an electronic apparatus comprising a glass substrate and, disposed thereon, a metallic electrode and an electronic device, the ribbon conductor being used for electrically connecting the metallic electrode to the electronic device or for electrically connecting the metallic electrode to an external electrode,
wherein the method comprises: coating a long ribbon-form copper foil or tin-plated copper foil with an indium solder on one side only or with an indium solder thinly in the parts other than one side; placing the resultant indium-solder-coated copper foil ribbon conductor on an exposed part of the metallic electrode layer so that the one side thickly coated with the indium solder is in contact with the metallic back electrode layer; and pushing an ultrasonic soldering iron with heating against the upper side of the indium-solder-coated copper foil ribbon conductor to melt the indium solder and connect the indium-solder-coated copper foil ribbon conductor to the metallic back electrode layer.

(10) The invention provides a method of connecting a copper foil ribbon conductor for CIS based thin-film solar cell module production, which is for connecting a CIS based thin-film solar cell circuit (submodule) to another CIS based thin-film solar cell circuit or to another electrical element, the CIS based thin-film solar cell circuit comprising a glass substrate and CIS based thin-film solar cell device parts disposed thereon which each comprise a metallic back electrode layer comprising molybdenum, an alkali barrier layer, a light absorption layer, a buffer layer, and a window layer (transparent electrode layer) in this order and which have been electrically connected to each other with a conductive pattern,
wherein the method comprises: soldering an indium solder beforehand to an exposed part of the metallic back electrode layer; placing a long ribbon-form copper foil or tin-plated copper foil on the indium solder layer; and pushing an ultrasonic soldering iron against the upper side of the ribbon-form copper foil or tin-plated copper foil to melt the indium solder and connect the ribbon-form copper foil or tin-plated copper foil to the metallic back electrode layer.

(11) The invention provides a method of connecting a copper foil ribbon conductor in an electronic apparatus comprising a glass substrate and, disposed thereon, a metallic electrode and an electronic device, the ribbon conductor being used for electrically connecting the metallic electrode to the electronic device or for electrically connecting the metallic electrode to an external electrode,
wherein the method comprises: soldering an indium solder beforehand to an exposed part of the metallic electrode layer; placing a long ribbon-form copper foil or tin-plated copper foil on the indium solder layer; and pushing an ultrasonic soldering iron with heating against the upper side of the ribbon-form copper foil or tin-plated copper foil to melt the indium solder and connect the ribbon-form copper foil or tin-plated copper foil to the metallic back electrode layer.

(12) The invention provides the method of connecting a copper foil ribbon conductor for CIS based thin-film solar cell module production or in an electronic apparatus as described under any one of (8) to (11) above, wherein the long ribbon-form copper foil or tin-plated copper foil has a thickness of 300 µm or smaller, the indium solder has a composition comprising 100-90% by weight of indium and 10-0% by weight of silver, and the indium solder deposited on the one side has a thickness of 100 µm or smaller.

### ADVANTAGES OF THE INVENTION

The indium-solder-coated copper foil ribbon conductor of the invention, i.e., an indium-solder-coated copper foil ribbon conductor obtained by coating a long ribbon-form copper foil or tin-plated copper foil having a thickness of 300 µm or smaller with an indium solder on one side only or with an indium solder thickly on one side and thinly in the other parts, not only is effective in reducing the amount of an indium solder to be used, which is expensive, but also can be bonded and connected with certainty to a metallic back electrode layer, another electrode, or conductive film formed on a glass substrate, without damaging the metallic back electrode layer or the like. Thus, the strain caused by a difference in the coefficient of thermal expansion between the materials connected can be mitigated by the indium, which is soft.

The method of connection of the invention using an indium-solder-coated copper foil ribbon conductor in the thin-film solar cell or another electronic apparatus, i.e., the method of connecting an indium-solder-coated copper foil ribbon conductor in which an indium-solder-coated copper foil ribbon conductor obtained by coating a long ribbon-form copper foil or tin-plated copper foil having a thickness of 300 µm or smaller with an indium solder composed of 100-90% by weight of indium and 10-0% by weight of silver on one side only or with the indium solder thickly on one side and thinly in the other parts is placed on an exposed part of a metallic back electrode layer so that the indium-solder-coated side is in contact with the layer and an ultrasonic soldering iron is pushed with heating against the upper side of the indium-solder-coated copper foil ribbon conductor to melt the indium solder and connect the indium-solder-coated copper foil ribbon conductor to the metallic back electrode layer (or another electrode, etc.) (method 1), is effective in tenaciously connecting the indium-solder-coated copper foil ribbon conductor to the metallic back electrode layer (or another electrode, etc.) without damaging the metallic back electrode layer.

The method of connection of the invention using an indium-solder-coated copper foil ribbon conductor in the thin-film solar cell or another electronic apparatus, i.e., the method of connecting a copper foil ribbon conductor which includes soldering an indium solder composed of 100-90% by weight and 0-10% by weight of silver beforehand to an exposed part of a metallic electrode layer formed on a glass substrate, placing thereon a long ribbon-form copper foil or tin-plated copper foil having a thickness of 300 µm or smaller, and pushing an ultrasonic soldering iron with heating against the upper side of the ribbon-form copper foil or tin-plated copper foil to melt the indium solder and connect the ribbon-form copper foil or tin-plated copper foil to the metallic back electrode layer (or another electrode, etc.) (method 1), is effective in tenaciously connecting the copper foil or tin-plated copper foil ribbon conductor to the metallic back electrode layer (or another electrode, etc.) without damaging the metallic back electrode layer.

Compared to method 2 (two steps), method 1 (one step) is smaller in the number of steps and in the amount of the indium solder to be used. Method 1 is can hence attain a reduction in production cost. In addition, method 1 can tenaciously connect the ribbon conductor to the metallic back electrode layer with higher certainty.

### BRIEF DESCRIPTION OF THE DRAWINGS

[Fig. 1] Fig. 1 is diagrammatic views illustrating the constitutions of indium-solder-coated copper (Cu) foil ribbon conductors of the invention.
[Fig. 2] Fig. 2 is a view illustrating a process of the invention for producing an indium-solder-coated copper (Cu) foil ribbon conductor.
[Fig. 3] Fig. 3 is a view illustrating a method of the invention for connecting an indium-solder-coated copper (Cu) foil ribbon conductor (method 1).
[Fig. 4] Fig. 4 is a view illustrating a method of the invention for connecting a ribbon conductor constituted of a copper foil or tin-plated copper foil.

### DESCRIPTION OF THE REFERENCE NUMERALS AND SIGNS

1: indium-solder-coated copper (Cu) foil ribbon conductor
2: copper (Cu) foil or tin-plated copper (Cu) foil
3: indium solder
3A: molten indium solder
4A: glass substrate
4B: molybdenum-based metallic back electrode layer
4C: solar cell device part
5: ultrasonic soldering iron

### BEST MODE FOR CARRYING OUT THE INVENTION

The invention relates to an indium-solder-coated tin-plated copper foil ribbon conductor suitable for conductor connection between an electrode film (or layer) or conductive film (or layer) of an electronic apparatus mounted on a glass substrate, such as, e.g., a CIS based thin-film solar cell, silicon-based thin-film solar cell, liquid-crystal display panel, or plasma display panel, and a ribbon conductor (copper foil or tin-plated copper foil ribbon conductor), and also to a method of conductor connection using this indium solder or indium-solder-coated tin-plated copper foil ribbon conductor.
In those electronic apparatus, the electrode films (or layers) or conductive films (or layers) are formed on a glass substrate. The material of the films therefore is a metal other than copper, such as, e.g., molybdenum, or ITO (transparent conductive film). These films (or layers) have an exceedingly small thickness and low mechanical strength and are apt to be damaged.
Because of this, solders for use in conductor connection in electronic apparatus mounted on substrates other than glass substrates or methods of conductor connection with these solders cannot be directly utilized.

A solder suitable for conductor connection between an electrode film or conductive film of an electronic apparatus mounted on a glass substrate, such as, e. g., a CIS based thin-film solar cell, silicon-based thin-film solar cell, or liquid-crystal display, and a ribbon conductor (copper foil or tin-plated copper foil ribbon conductor) was hence selected and developed first.
It was found that an indium solder composed of 100-90% by weight of indium and 10-0% by weight of silver, preferably composed of about 100-97% by weight of indium and about 3-0% by weight of silver, is optimal for the conductor connection.

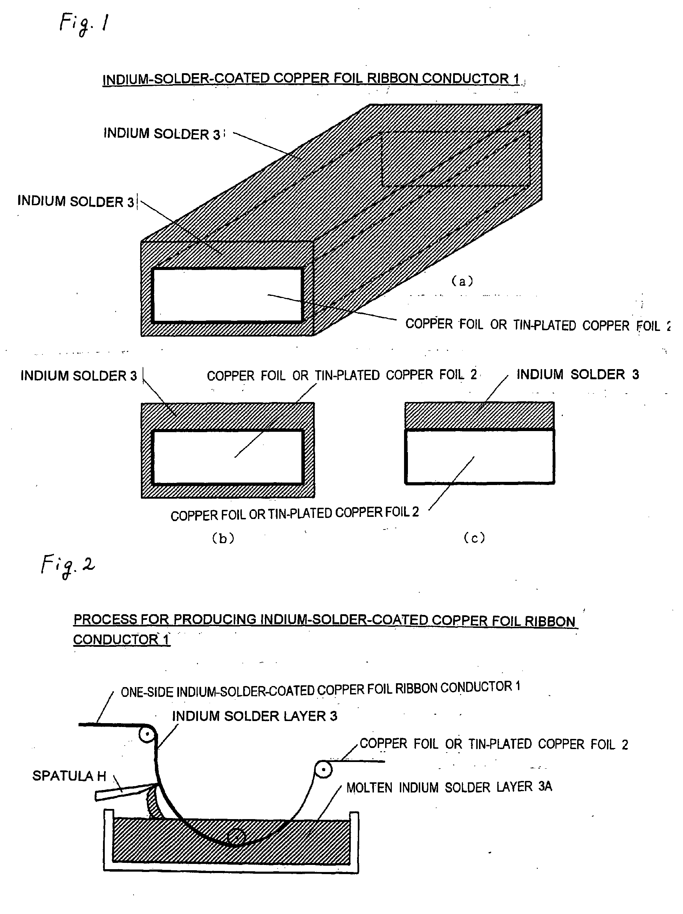

The indium-solder-coated copper foil (copper foil or tin-plated copper foil) ribbon conductor according to a first aspect of the invention is explained below.
As shown in Fig. 1, an indium-solder-coated tin-plated copper foil ribbon conductor 1 (see Fig. 1 (c)) is preferred which is obtained by coating one side (either of the upper and lower sides) of a long ribbon-form copper foil or tin-plated copper foil 2 having a thickness of 300 µm or smaller, preferably about 150-160 µm, with the indium solder 3 (composed of 100-90% by weight of indium and 10-0% by weight of silver, preferably of about 100-97% by weight of indium and about 3-0% by weight of silver) in a thickness of 100 µm or smaller, preferably about 40 µm.

However, when the indium-solder-coated copper foil ribbon conductor 1 is to be coated with the indium solder 3, the parts other than the upper or lower side of the tin-plated copper (Cu) foil 2 are also coated with the indium solder 3. Consequently, an indium-solder-coated copper foil ribbon conductor 1 may be produced by coating either of the upper and lower sides of a copper foil or tin-plated copper foil 2 with an indium solder in a thickness of 100 µm or smaller (preferably about 40 µm) and regulating the indium solder deposition amount (thickness) on the other surfaces so as to be smaller than on that one side as shown in Fig. 1 (a) and (b). Even when this indium-solder-coated copper foil ribbon conductor 1 is used, no problem arises.

An explanation is then given on the process according to a second aspect of the invention for producing the indium-solder-coated copper foil ribbon conductor 1 which is constituted of a copper (Cu) foil or tin-plated copper (Cu) foil 2 coated with an indium solder on one side only or coated with an indium solder thickly on one side and thinly in the other parts and in which the indium solder (composed of 100-90% by weight and 0-10% by weight of silver, preferably of about 100-97% by weight of indium and about 3-0% by weight of silver) on the one side has a thickness of 100 µm or smaller (preferably about 40 µm).
As shown in Fig. 2, the long ribbon-form copper foil or tin-plated copper foil 2 having a thickness of 300 µm or smaller, preferably about 150-160 µm, is immersed, gradually from an end thereof, in a molten indium solder (composed of 100-90% by weight of indium and 0-10% by weight of silver) 3A to coat the whole periphery of the ribbon-form copper foil or tin-plated copper-foil 2 with the indium solder 3. Thereafter, the coated foil 2 is drawn out of the molten indium solder 3A, and the molten indium solder 3A adherent to the lower side of the copper foil 2 is removed (wiped off) with a solder remover, e.g., a metallic spatula H. Thus, an indium-solder-coated copper foil ribbon conductor 1 is produced in which the upper side of the foil has been coated with the indium solder 3 (composed of 100-90% by weight of indium and 0-10% by weight of silver, preferably of about 100-97% by weight of indium and about 0-3% by weight of silver) in a thickness of 100 µm or smaller, preferably about 40 µm.
In producing the indium-solder-coated copper foil ribbon conductor 1 in which one side of the copper foil or tin-plated copper foil 2 has been coated with an indium solder, it is impossible to completely remove the indium solder 3 adherent to the lower side and lateral sides in the solder removal step. Even when the indium solder 3 remains adherent to these sides, use of this ribbon conductor 1 does not pose a problem.
By thus removing the unnecessary indium solder 3 to thereby reduce the amount of the expensive indium solder to be used, production cost can be reduced.

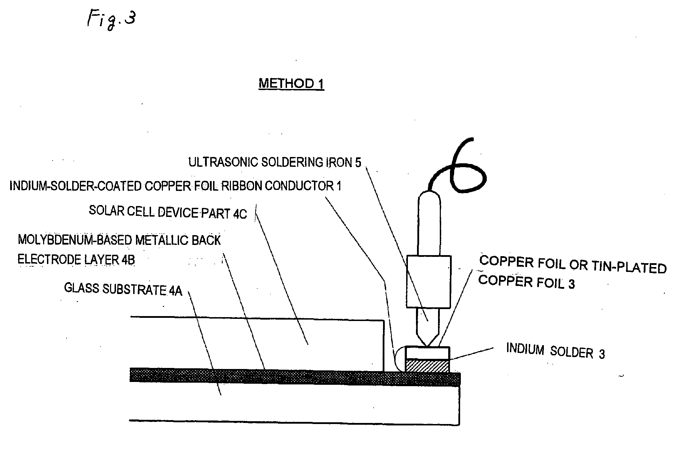

A method of conductor-to-conductor connection in an electronic apparatus mounted on a glass substrate, according to a third aspect of the invention, is explained below, in which the indium-solder-coated copper foil ribbon conductor 1 is used.
In the following explanation, a CIS based thin-film solar cell module is used as an example of the electronic apparatus mounted on a glass substrate.
A CIS based thin-film solar cell module includes a CIS based thin-film solar cell circuit (submodule) including a glass substrate 4A and CIS based thin-film solar cell device parts 4C disposed thereon which each are composed of a metallic back electrode layer made of molybdenum, an alkali barrier layer, a light absorption layer, a buffer layer, and a window layer (transparent electrode layer) in this order and which have been electrically connected to each other with a conductive pattern. For connecting these solar cell device parts 4C to one another or to another electrical element, it is necessary to connect conductors with a ribbon conductor including the copper foil or tin-plated copper foil 2. In this method of conductor-to-conductor connection (method 1) of the invention, an indium-solder-coated copper foil ribbon conductor 1 obtained by coating a long ribbon-form copper foil or tin-plated copper foil 2 having a thickness of 300 µm or smaller, preferably about 150-160 µm, with an indium solder (composed of 100-90% by weight of indium and 0-10% by weight of silver, preferably of about 100-97% by weight of indium and about 3-0% by weight of silver) on one side only or with the indium solder thickly on one side and thinly in the other parts so that the indium solder deposited on the one side has a thickness of 100 µm or smaller, preferably about 40 µm (see Fig. 1), is placed on an exposed part of the molybdenum-based metallic back electrode layer 4B so that the indium-solder-coated side 3 is in contact with the metallic back electrode layer 4B. An ultrasonic soldering iron 5 is pushed against the upper side of the indium-solder-coated copper foil ribbon conductor 1 to melt the indium solder 3 and connect the indium-solder-coated copper foil ribbon conductor 1 to the metallic back electrode layer 4B as shown in Fig. 3.
Although molybdenum was used as an example of the material of the metallic back electrode layer, other metallic materials are also usable.

By the method of conductor-to-conductor connection (method 1) described above, the indium-solder-coated copper foil ribbon conductor 1 can be tenaciously connected to the metallic back electrode layer (or another electrode, etc.) 4B at a low temperature through a simple step with certainty without damaging the metallic back electrode layer 4B. Furthermore, the strain caused by a difference in the coefficient of thermal expansion between the materials connected can be mitigated by the indium, which is soft.
The method of conductor-to-conductor connection (method 1) described above should not be construed as being used only for conductor-to-conductor connection in a CIS based thin-film solar cell module. The method is usable in electronic apparatus including a glass substrate and, disposed thereon, a metallic electrode and an electronic device, and also in silicon-based thin-film solar cells, liquid-crystal display panels, plasma display panels, and other electronic apparatus.

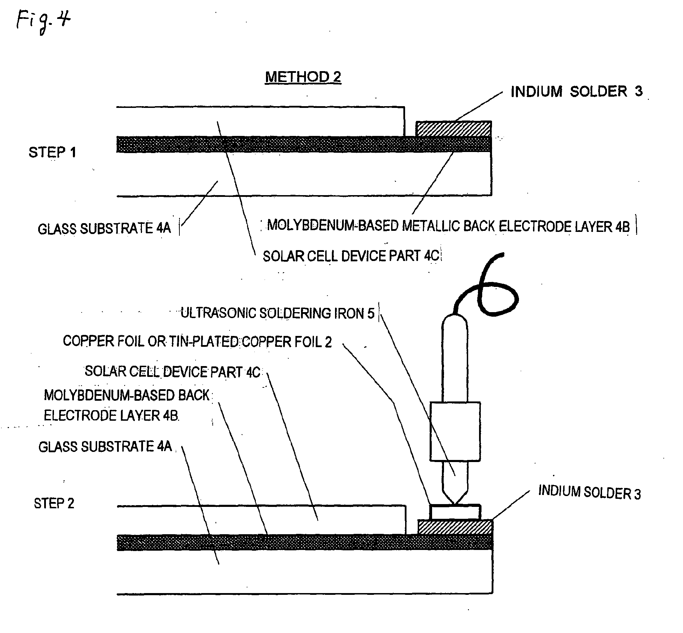

Another method of conductor-to-conductor connection in an electronic apparatus mounted on a glass substrate, according to a fourth aspect of the invention, is explained below, in which the indium-solder-coated copper foil ribbon conductor 1 is used (method 2). (A CIS based thin-film solar cell module is used below as an example of the electronic apparatus mounted on a glass substrate.)
As shown in Fig. 4, an indium solder 3 composed of 100-90% by weight of indium and 0-10% by weight of silver, preferably of about 100-97% by weight of indium and about 3-0% by weight of silver, is soldered beforehand to an exposed part of a metallic back electrode layer 4B (step 1). A long ribbon-form copper foil or tin-plated copper foil 2 having a thickness of 300 µm or smaller, preferably about 150-160 µm, is placed on the indium solder layer 3. An ultrasonic soldering iron 5 is pushed against the upper side of the copper foil or tin-plated copper foil 2 to melt the indium solder 3 and connect the ribbon-form copper foil or tin-plated copper foil 2 to the metallic back electrode layer 4B (step 2).
By the method of conductor-to-conductor connection (method 2) described above, the ribbon conductor constituted of the copper foil or tin-plated copper foil 2 can be tenaciously connected to the metallic back electrode layer (or another electrode, etc.) 4B at a low temperature through simple steps with certainty without damaging the metallic back electrode layer 4B. Furthermore, the strain caused by a difference in the coefficient of thermal expansion between the materials connected can be mitigated by the indium, which is soft.
The method of conductor-to-conductor connection (method 2) described above should not be construed as being used only for conductor-to-conductor connection in a CIS based thin-film solar cell module. The method is usable in electronic apparatus including a glass substrate and, disposed thereon, a metallic electrode and an electronic device, and also in silicon-based thin-film solar cells, liquid-crystal display panels, plasma display panels, and other electronic apparatus.

This method of conductor-to-conductor connection (method 2) additionally necessitates the step of soldering an indium solder 3 beforehand. This method hence includes a larger number of steps than the method of conductor-to-conductor connection described above (method 1). Method 1 (see Fig. 3) is superior also in the strength of bonding between the metallic back electrode layer and the ribbon conductor.

### INDUSTRIAL APPLICABILITY

According to the constitutions (1) to (12) of the invention, the amount of an indium solder to be used, which is expensive, can be reduced and the indium-solder-coated copper foil ribbon conductor can be bonded and connected with certainty to a metallic back electrode layer, another electrode, or conductive film formed on a glass substrate, without damaging the metallic back electrode layer or the like. The strain caused by a difference in the coefficient of thermal expansion between the materials connected can be mitigated by the indium, which is soft. The invention has exceedingly high industrial applicability.

## Claims

1. An indium-solder-coated copper foil ribbon conductor, which comprises a long ribbon-form copper foil or tin-plated copper foil which has been coated with an indium solder on one side only or coated with an indium solder thickly on one side and thinly in the other parts.

2. The indium-solder-coated copper foil ribbon conductor according to claim 1, wherein the long ribbon-form copper foil or tin-plated copper foil has a thickness of 300 µm or smaller, the indium solder has a composition comprising 100-90% by weight of indium and 10-0% by weight of silver, and the indium solder deposited on the one side has a thickness of 100 µm or smaller.

3. The indium-solder-coated copper foil ribbon conductor according to claim 1 or 2, which is used for connecting a CIS based thin-film solar cell circuit (submodule) to another CIS based thin-film solar cell circuit or to another electrical element, wherein the CIS based thin-film solar cell circuit comprises a glass substrate and CIS based thin-film solar cell device parts disposed thereon which each comprise a metallic back electrode layer comprising molybdenum, an alkali barrier layer, a light absorption layer, a buffer layer, and a window layer (transparent electrode layer) in this order and which have been electrically connected to each other with a conductive pattern.

4. The indium-solder-coated copper foil ribbon conductor according to claim 1 or 2, which is used in an electronic apparatus comprising a glass substrate and, disposed thereon, a metallic electrode and an electronic device, wherein the ribbon conductor is used for electrically connecting the metallic electrode to the electronic device or for electrically connecting the metallic electrode to an external electrode.

5. A process for producing an indium-solder-coated copper foil ribbon conductor, which comprises immersing a long ribbon-form copper foil or tin-plated copper foil, gradually from an end thereof, in a molten indium solder, subsequently drawing the foil out of the molten indium solder, and removing (wiping off) the molten indium solder adherent to the lower side of the copper foil with a solder remover, e.g., a metallic spatula, to coat either of the upper and lower sides of the copper foil or tin-plated copper foil with the indium solder.

6. A process for producing an indium-solder-coated copper foil ribbon conductor, which comprises immersing a long ribbon-form copper foil or tin-plated copper foil, gradually from an end thereof, in a molten indium solder to coat the whole periphery of the ribbon-form copper foil or tin-plated copper foil with the indium solder, subsequently drawing the coated foil out of the molten indium solder, and removing (wiping off) the molten indium solder adherent to the lower side of the copper foil with a solder remover, e.g., a metallic spatula, to regulate the indium solder deposited on the upper side so as to have a larger thickness than the indium solder deposited on the lower side.

7. The process for producing an indium-solder-coated copper foil ribbon conductor according to claim 5 or 6, wherein the long ribbon-form copper foil or tin-plated copper foil has a thickness of 300 µm or smaller, the indium solder has a composition comprising 100-90% by weight of indium and 10-0% by weight of silver, and wherein the indium solder deposited on the one side has a thickness of 100 µm or smaller.

8. A method of connecting a copper foil ribbon conductor for CIS based thin-film solar cell module production, which is for connecting a CIS based thin-film solar cell circuit (submodule) to another CIS based thin-film solar cell circuit or to another electrical element, wherein the CIS based thin-film solar cell circuit comprises a glass substrate and CIS based thin-film solar cell device parts disposed thereon which each comprise a metallic back electrode layer comprising molybdenum, an alkali barrier layer, a light absorption layer, a buffer layer, and a window layer (transparent electrode layer) in this order and which have been electrically connected to each other with a conductive pattern,
wherein the method comprises: coating a long ribbon-form copper foil or tin-plated copper foil with an indium solder on one side only or with an indium solder thickly on one side and thinly in the other parts; placing the resultant indium-solder-coated copper foil ribbon conductor on an exposed part of the metallic back electrode layer so that the one side thickly coated with the indium solder is in contact with the metallic back electrode layer; and pushing an ultrasonic soldering iron against the upper side of the indium-solder-coated copper foil ribbon conductor to melt the indium solder and connect the indium-solder-coated copper foil ribbon conductor to the metallic back electrode layer.

9. A method of connecting a copper foil ribbon conductor in an electronic apparatus comprising a glass substrate and, disposed thereon, a metallic electrode and an electronic device, wherein the ribbon conductor is used for electrically connecting the metallic electrode to the electronic device or for electrically connecting the metallic electrode to an external electrode,
wherein the method comprises: coating a long ribbon-form copper foil or tin-plated copper foil with an indium solder on one side only or with an indium solder thinly in the parts other than one side; placing the resultant indium-solder-coated copper foil ribbon conductor on an exposed part of the metallic electrode layer so that the one side thickly coated with the indium solder is in contact with the metallic back electrode layer; and pushing an ultrasonic soldering iron with heating against the upper side of the indium-solder-coated copper foil ribbon conductor to melt the indium solder and connect the indium-solder-coated copper foil ribbon conductor to the metallic back electrode layer.

10. A method of connecting a copper foil ribbon conductor for CIS based thin-film solar cell module production, which is for connecting a CIS based thin-film solar cell circuit (submodule) to another CIS based thin-film solar cell circuit or to another electrical element, wherein the CIS based thin-film solar cell circuit comprises a glass substrate and CIS based thin-film solar cell device parts, disposed thereon, which each comprises a metallic back electrode layer comprising molybdenum, an alkali barrier layer, a light absorption layer, a buffer layer, and a window layer (transparent electrode layer) in this order and which have been electrically connected to each other with a conductive pattern,
wherein the method comprises: soldering an indium solder beforehand to an exposed part of the metallic back electrode layer; placing a long ribbon-form copper foil or tin-plated copper foil on the indium solder layer; and pushing an ultrasonic soldering iron against the upper side of the ribbon-form copper foil or tin-plated copper foil to melt the indium solder and connect the ribbon-form copper foil or tin-plated copper foil to the metallic back electrode layer.

11. A method of connecting a copper foil ribbon conductor in an electronic apparatus comprising a glass substrate and, disposed thereon, a metallic electrode and an electronic device, the ribbon conductor being used for electrically connecting the metallic electrode to the electronic device or for electrically connecting the metallic electrode to an external electrode,
wherein the method comprises: soldering an indium solder beforehand to an exposed part of the metallic electrode layer; placing a long ribbon-form copper foil or tin-plated copper foil on the indium solder layer; and pushing an ultrasonic soldering iron with heating against the upper side of the ribbon-form copper foil or tin-plated copper foil to melt the indium solder and connect the ribbon-form copper foil or tin-plated copper foil to the metallic back electrode layer.

12. The method of connecting a copper foil ribbon conductor for CIS based thin-film solar cell module production or in an electronic apparatus according to any one of claims 8 to 11, wherein the long ribbon-form copper foil or tin-plated copper foil has a thickness of 300 µm or smaller, the indium solder has a composition comprising 100-90% by weight of indium and 10-0% by weight of silver, and the indium solder deposited on the one side has a thickness of 100 µm or smaller.
